# FASCICULE DE BREVET EUROPEEN

(11) **EP 0 612 461 B1**
(45) Date de publication et mention de la délivrance du brevet: **19.07.1995**
(21) Numéro de dépôt: 93900238.2
(22) Date de dépôt: 10.11.1992
(51) Int. Cl.: H04R 3/04, H03G 5/16

(54) **PROCEDE ET DISPOSITIF D'EGALISATION DYNAMIQUE**
VERFAHREN UND GERÄT ZUR ENTZERRUNG
METHOD AND DEVICE FOR DYNAMIC EQUALIZATION

(30) Priorité: 12.11.1991 FR 9113889
(43) Date de publication de la demande: 31.08.1994
(73) Titulaire: S L X S.A.R.L., F-92400 Courbevoie (FR)
(72) Inventeur: CARPENTIER, Claude, F-92400 Courbevoie (FR)
(74) Mandataire: Casalonga, Axel
(86) Numéro de dépôt international: FR9201043
(87) Numéro de publication internationale: WO9310646

(56) Documents cités:
- US-A- 4 755 771
- PATENT ABSTRACTS OF JAPAN vol. 4, no. 052 (E-007)18 Avril 1980
- PATENT ABSTRACTS OF JAPAN vol. 9, no. 165 (E-327)10 Juillet 1985

## Description

### Procédé et dispositif d'égalisation dynamique

La présente invention concerne un procédé et un dispositif d'égalisation pour amplificateur audio fréquences destiné à la reproduction sonore.

On connait du document US-A-4 755 771 un dispositif de réglage de la bande passante d'une ligne de transmission de signaux en fonction de sa longueur, le gain dudit dispositif étant asservi de façon continue et étant contrôlé et commandé par le dispositif de détection de crêtes.

Pour la reproduction sonore, l'égalisation consiste à obtenir soit un équilibre sonore le plus proche possible de l'original en corrigeant les défauts de linéarité de la courbe de réponse du système transducteur constitué par une ou plusieurs enceintes acoustiques pourvues de hauts-parleurs, ce qui correspond à la notion de haute fidélité, soit à un son façonné au goût de l'auditeur. Dans le premier cas, le rôle du dispositif d'égalisation ou égaliseur est purement technique, dans le second, l'égaliseur joue le rôle de correcteur de tonalité sophistiquée.

La courbe de réponse d'une enceinte acoustique dans un local présente deux types de perturbation : d'une part des accidents en dent de scie très pointus et d'autre part de larges ondulations. Dans le bas du spectre des fréquences audibles, ces deux types de perturbation se confondent.

Les accidents en dents de scie ont pour origine l'intéraction entre l'onde sonore directe et les ondes sonores réfléchies. Lorsque l'onde directe et la résultante des ondes réfléchies sont en phase, la courbe de réponse présente un pic d'environ 6 dB par rapport à la pression anéchoïde qui est due uniquement à l'onde directe. Lorsque la résultante des ondes réfléchies est en opposition de phase avec l'onde directe, la courbe de réponse présente un creux et, en théorie, la pression acoustique peut s'annuler.

Les ondulations plus larges sont imputables quant à elles à la non-linéarité de la courbe de réponse de l'enceinte sous l'angle d'écoute.

Avec les dispositifs d'égalisation connus, l'égalisation est obtenue en intercalant de manière permanente sur le parcours du signal, des filtres passe-bandes destinés à combler les creux de la courbe de réponse, et des filtres coupe-bandes destinés à en écrêter les pics.

Cette manière de procéder d'une part donne de bons résultats pour la correction des ondulations provenant de la non-linéarité de la courbe de réponse de l'enceinte, mais d'autre part provoque un effet pervers lorsqu'elle est appliquée à la correction des accidents pointus ayant pour origine la combinaison de l'onde directe et des ondes réfléchies dans un local.

En effet, le demandeur a découvert, lors des études qu'il a menées sur les phénomènes transitoires, que la combinaison entre l'onde directe et les ondes réfléchies s'effectuait progressivement et n'atteignait son régime stationnaire qu'au bout d'un temps qui peut atteindre 100 ms dans une pièce de dimension courante, par exemple un salon de 100 m³. Cet effet peut être désigné par "l'effet local".

Or, un pic du signal provenant d'une attaque sonore d'un instrument est toujours atteint dans les dix premières millisecondes, alors que l'effet local n'a par encore eu lieu. Ce qui signifie que seul l'onde directe est parvenue à l'auditeur.

Etant donné que les égaliseurs traditionnels ne prennent en compte que les phénomènes stationnaires en faisant l'impasse complète sur la reproduction des phénomènes transitoires, une attaque instrumentale dont la fondamentale correspond à un pic de résonance qui est corrigé par un égaliseur traditionnel voit sa dynamique de signal amputée d'environ de 6 dB, soit un rapport de 1 à 4 en puissance. Il est en de même lorsque l'on corrige un creux en ajustant une plage de fréquence à l'aide d'un égaliseur traditionnel, on augmente artificiellement la dynamique dans cette zone de fréquence.

Le but de l'invention est de proposer un procédé et un dispositif d'égalisation prenant en compte les phénomènes transitoires.

Plus particulièrement, l'invention a pour but un procédé et un dispositif d'égalisation permettant de prendre en compte l'effet local tout en conservant la dynamique originale des attaques.

Le procédé d'égalisation pour l'amplification de signaux audio fréquences selon l'invention, consiste à disposer d'un premier moyen de correction de la courbe de réponse pour le régime stationnaire, à disposer d'au moins un second moyen de correction ayant un gain différent de celui du premier moyen de correction et destiné à corriger la courbe de réponse pour le régime transitoire, à discriminer le régime transitoire et à commander la commutation entre le premier et le second moyen de correction.

De préférence, la discrimination du régime transitoire et la commutation du premier moyen de correction vers second moyen de correction sont effectués pendant une durée inférieure à 5 ms, de façon à réagir immédiatement en augmentant le gain s'il s'agit d'une attaque, ou en diminuant le gain s'il s'agit d'un creux.

A la fin du régime transitoire, une commutation a lieu pour faire passer du second moyen de correction pour le régime transitoire au premier moyen de correction pour le régime stationnaire.

Le retour au premier moyen de correction pour le régime stationnaire sera de préférence effectué progressivement dès l'arrêt de la montée du signal et sur une durée comprise entre 30 ms et 100 ms variable en fonction des caractéristiques du local. De manière simplifiée, on peut effectuer la commutation instantanément après une brève période comprise entre 30 ms et 100 ms par rapport au régime transitoire.

Le dispositif d'égalisation pour amplificateur audio fréquences selon l'invention, comprend un premier moyen de correction pour le régime stationnaire, au moins un second moyen de correction pour le régime transitoire avec un gain différent du premier moyen de correction, un moyen de discrimination du régime transitoire et un moyen de commutation du premier moyen de correction au second moyen de correction et vice versa, le moyen de commutation étant commandé par le moyen de discrimination du régime transitoire.

Le dispositif peut comprendre un moyen de temporisation pour le retour au premier moyen de correction après le régime transitoire. Les premier et second moyens de correction peuvent être constitués par une seule cellule dont le gain peut prendre deux valeurs par simple commutation d'une résistance.

L'invention sera mieux comprise à l'aide de la description détaillée d'un mode de réalisation pris à titre nullement limitatif et illustré par les dessins annexés, sur lesquels :
la figure 1 est un schéma électrique d'un égaliseur traditionnel, et
la figure 2 est un schéma électrique d'un égaliseur selon l'invention.

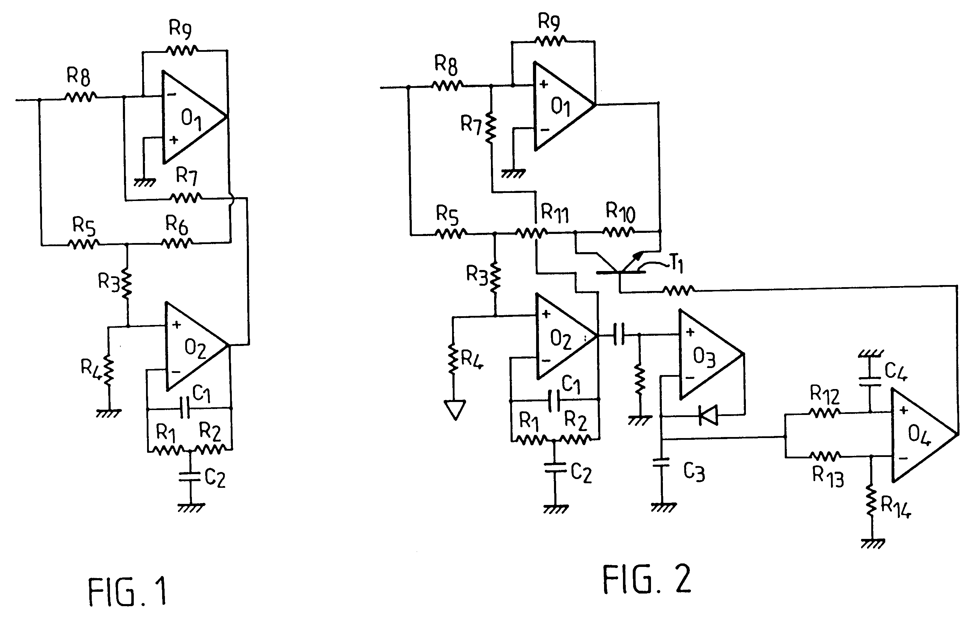

La figure 1 représente une cellule d'égalisation de type connu. Dans cette cellule, un amplificateur opérationnel O2 est monté en filtre passe-bande de fréquence réglable par des résistances R1 et R2 de valeurs égales. L'amplificateur O2 est alimenté par un pont diviseur que constituent des résistances R3 et R4. Un second amplificateur O1 est monté en mélangeur de gain unitaire inversant la phase.

Des résistances R5 et R6 de valeurs variables constituent un ensemble potentiométrique. Lorsque la valeur de R5 est égale à zéro, le signal de sortie de l'amplificateur O2 est en phase avec le signal d'entrée de l'amplificateur O1. Le gain de l'ensemble est alors maximum à la fréquence d'accord de l'amplificateur O2.

Lorsque la valeur de R6 est égale à zéro, le signal de sortie de l'amplificateur O2 est en opposition de phase avec le signal d'entrée de l'amplificateur O1. Le gain de l'ensemble est alors minimum à la fréquence d'accord de l'amplificateur O2.

Lorsque les valeurs de R5 et de R6 sont égales, la tension du signal au point commun des résistances R5 et R6 est nulle, ce qui annule également l'action de l'amplificateur opérationnel O2.

En conséquence, on fait varier le gain du filtre passe-bande en réglant le rapport R5/R6, et la largeur de la bande passante en réglant le rapport R3/R4.

La figure 2 représente un dispositif d'égalisation conforme à l'invention en utilisant comme schéma de base le circuit électrique de la figure 1. Dans ce schéma, la résistance R5 est devenue fixe et la résistance R6 remplacée par un couple de résistance R10 et R11.

Le dispositif comprend en outre un transistor T1 du type NPN, un détecteur de crêtes O3 et un discriminateur O4. Lorsque le transistor T1 est passant, la résistance R10 est court-circuitée.

Selon l'invention, en faisant varier les valeurs respectives des résistances R5, R10 et R11, le gain GT pour le régime transitoire et le gain GS pour le régime stationnaire peuvent prendre toutes les valeurs comprises entre un seuil maximum et un seuil minimum. Lorsque l'on réduit la valeur de la résistance R10 à zéro, le transistor T1 est court-circuité, le dispositif fonctionne alors comme la cellule de la figure 1.

La discrimination entre le régime transitoire et le régime stationnaire se fait de la manière suivante. Le signal issu du filtre passe-bande O2 est détecté par le détecteur de crêtes O3 relié au discriminateur O4. En régime stationnaire, la sortie du discriminateur O4 est haute, car l'entrée (-) du discriminateur O4 est à un potentiel légèrement plus faible que l'entrée (+) dudit discriminateur à cause d'un pont diviseur constitué par deux résistances R13 et R14. Le transistor T1 est passant et court-circuite la résistance R10, ce qui a pour conséquence une diminution du gain du dispositif.

Lorsque la modulation augmente brusquement, la constante de temps du circuit R12/C4 fait que le potentiel de l'entrée (-) du discriminateur O4 devient supérieur au potentiel de l'entrée (+) dudit discriminateur. La sortie du discriminateur O4 bascule vers le bas, ce qui a pour conséquence de rendre le transistor T1 non conducteur. Le gain du dispositif augmente.

De préférence, la commutation entre les deux gains du dispositif s'effectue à l'aide du discriminateur lors d'un passage à zéro du signal. Cette tache peut être accomplie par un détecteur de zéro non représenté relié au discriminateur O4.

Après la montée de la modulation du signal, le potentiel de l'entrée (+) du discriminateur O4 rattrape celui de l'entrée (-) du discriminateur de façon à le faire rebasculer vers le haut. Le transistor T1 redevient passant et le gain du dispositif diminue. De façon avantageuse, le rebasculement du discriminateur O4 s'effectue après une période de temporisation dont la durée est réglable entre 30 ms et 100 ms.

De cette façon, on obtient bien le résultat escompté, à savoir une égalisation dynamique qui prend en compte pleinement du régime transitoire. Le réglage du discriminateur s'effectue en faisant varier les valeurs des capacités C3, C4 et des résistances R12, R13 et R14.

Pour traiter un creux en régime transitoire au lieu d'une crête, il suffit de remplacer le transistor T1 du type NPN par un transistor du type PNP pour obtenir un gain GT en régime transitoire inférieur au gain GS en régime stationnaire en utilisant le même schéma que celui de la figure 2.

## Revendications

1. Procédé d'égalisation pour l'amplification de signaux audio fréquences, caractérisé par le fait qu'il consiste à disposer d'un premier moyen de correction de la courbe de réponse pour le régime stationnaire, à disposer d'au moins un second moyen de correction dont le gain (GT) est différent du gain (GS) du premier moyen de correction et pour corriger la courbe de réponse en régime transitoire, à discriminer le régime transitoire et à commuter du premier moyen de correction au second moyen de correction lorsque le régime transitoire est discriminé, puis à commuter dans le sens inverse après le régime transitoire.

2. Procédé d'égalisation selon la revendication 1, caractérisé par le fait que la détection, la discrimination, et la commutation en présence d'un régime transitoire sont effectués pendant une durée totale inférieure à 5 ms.

3. Procédé d'égalisation selon la revendication 1 ou 2, caractérisé par le fait que la commutation du second moyen de correction au premier moyen de correction s'effectue après une durée comprise entre 30 ms et 100 ms par rapport au régime transitoire.

4. Procédé d'égalisation selon la revendication 1 ou 2, caractérisé par le fait que la commutation du second moyen de correction au premier moyen de correction s'effectue progressivement dès l'arrêt de la montée du signal et sur une durée comprise entre 30 ms et 100 ms.

5. Procédé d'égalisation selon l'une des revendications précédentes, caractérisé par le fait que la commutation entre les premier et second moyens de correction s'effectue lors d'un passage à zéro du signal.

6. Dispositif d'égalisation pour amplificateur audio fréquences, comprenant un premier moyen de correction pour le régime stationnaire, caractérisé par le fait qu'il comprend en outre au moins un second moyen de correction pour le régime transitoire et dont le gain (GT) est différent du gain (GS) du premier moyen de correction, un détecteur de crêtes (O3), un moyen de discrimination (O4) du régime transitoire relié au détecteur de crêtes, un moyen de commutation du premier moyen de correction au second moyen de correction et vice versa, le moyen de commutation étant commandé par le moyen de discrimination.

7. Dispositif d'égalisation selon la revendication 6, caractérisé par le fait que les premier et second moyens de correction sont constitués par une cellule unique dont le gain peut prendre deux valeurs par simple commutation d'une résistance (R10).

8. Dispositif d'égalisation selon la revendication 7, caractérisé par le fait que la commutation de la résistance (R10) s'effectue par l'intermédiaire d'un transistor (T1) commandé par le moyen de discrimination (O4).

9. Dispositif d'égalisation selon l'une des revendications 6 à 8, caractérisé par le fait qu'il comprend un détecteur de zéro associé au discriminateur (O4) afin de réaliser la commutation lors d'un passage à zéro du signal.

10. Dispositif d'égalisation selon l'une des revendications 6 à 9, caractérisé par le fait qu'il comprend un moyen de temporisation réglable pour le retour du second moyen de correction vers le premier moyen de correction après le régime transitoire.

## Patentansprüche

1. Entzerrungsverfahren für die Verstärkung von Tonfrequenzsignalen, dadurch gekennzeichnet, daß ein erstes Korrekturmittel für die Übertragungsfunktion für den stationären Betrieb vorgesehen wird, daß wenigstens ein zweites Korrekturmittel, dessen Verstärkung (GT) von der Verstärkung (GS) des ersten Korrekturmittels verschieden ist, zum Korrigieren der Übertragungsfunktion für den transienten Betrieb vorgesehen wird, daß der transiente Betrieb erkannt wird, daß von dem ersten Korrekturmittel zu dem zweiten Korrekturmittel umgschaltet wird, wenn der transiente Betrieb erkannt worden ist, und daß sodann nach dem transienten Betrieb in umgekehrtem Sinne zurückgeschaltet wird.

2. Entzerrungsverfahren nach Anspruch 1, dadurch gekennzeichnet, daß das Erfassen, das Unterscheiden und das Umschalten bei Vorliegen eines transienten Betriebes während einer Gesamtdauer durchgeführt wird, die kürzer ist als 5 ms.

3. Entzerrungsverfahren nach Anspruch 1 oder 2, dadurch gekennzeichnet, daß das Umschalten von dem zweiten Korrekturmittel auf das erste Korrekturmittel nach einer Dauer erfolgt, die zwischen 30 ms und 100 ms im Verhältnis zu dem transienten Betrieb gewählt ist.

4. Entzerrungsverfahren nach Anspruch 1 oder 2, dadurch gekennzeichnet, daß der Übergang von dem zweiten Korrekurmittel zu dem ersten Korrekturmittel von dem Ende des Anstieges des Signales fortschreitend und in einer zwischen 30 ms und 100 ms gewählten Dauer erfolgt.

5. Entzerrungsverfahren nach einem der vorhergehenden Ansprüche, dadurch gekennzeichnet, daß das Umschalten zwischen dem ersten und dem zweiten Korrekturmittel bei einem Nulldurchgang des Signales erfolgt.

6. Entzerrungseinrichtung für einen Tonfrequenzverstärker mit einem ersten Korrekturmittel für stationären Betrieb, dadurch gekennzeichnet, daß es unter anderem wenigstens ein zweites Korrekturmittel für transienten Betrieb, dessen Verstärkung (GT) von der Verstärkung (GS) des ersten Korrekturmittels verschieden ist, einen Spitzenwertdetektor (O3), ein Diskriminatormittel (O4) für den transienten Betrieb, das mit dem Spitzenwertdetektor verbunden ist, ein Mittel zum Umschalten von dem ersten Korrekturmittel zu dem zweiten Korrekturmittel und umgekehrt aufweist, wobei das Mittel zum Umschalten durch das Diskriminatormittel gesteuert ist.

7. Entzerrungseinrichtung nach Anspruch 6, dadurch gekennzeichnet, daß die zweiten Korrekturmittel durch eine einzelne Baugruppe gebildet werden, deren Verstärkung durch einfaches Umschalten eines Widerstandes (R10) zwei Werte annehmen kann.

8. Entzerrungseinrichtung nach Anspruch 7, dadurch gekennzeichnet, daß das Umschalten des Widerstandes (R1) mittels eines Transistors (T1) erfolgt, der durch das Diskriminatormittel (O4) gesteuert ist.

9. Entzerrungseinrichtung nach einem der Ansprüche 6 bis 8, dadurch gekennzeichnet, daß sie einen Nulldurchgangsdetektor aufweist, der mit dem Diskriminator (O4) verbunden ist, um das Umschalten während eines Nulldurchganges des Signales zu realisieren.

10. Entzerrungseinrichtung nach einem der Ansprüche 6 bis 9, dadurch gekennzeichnet, daß sie ein einstellbares, zeitbestimmendes Mittel für die Rückkehr von dem zweiten Korrekturmittel zu dem ersten Korrekturmittel nach dem transienten Betrieb aufweist.

## Claims

1. Equalization method for amplification of audio frequency signals characterized in that it provides first means for correcting the response curve for stable conditions and at least one second correction means whose gain (GT) is different from the gain (GS) of the first correction means for correcting the response curve under transient conditions, discriminates transients, switches from the first correction means to the second correction means when a transient is discriminated and switches in the opposite direction after the transient.

2. Equalization method according to claim 1 characterized in that detection, discrimination and switching in the presence of a transient are effected within a total time of less than 5 ms.

3. Equalization method according to claim 1 or claim 2 characterized in that switching from the second correction means to the first correction means is effected after a time-delay relative to the transient of between 30 ms and 100 ms.

4. Equalization method according to claim 1 or claim 2 characterized in that switching from the second correction means to the first correction means is effected progressively as soon as the signal stops rising and in a time between 30 ms and 100 ms.

5. Equalization method according to any one of the preceding claims characterized in that switching between the first and second correction means is effected at a zero-crossing of the signal.

6. Equalizer device for audio frequency amplifiers comprising first correction means for stable conditions characterized in that it further comprises at least one second correction means for transient conditions whose gain (GT) is different from the gain (GS) of the first correction means, a peak detector (O3), transient discriminator means (O4) connected to the peak detector, and means for switching from the first correction means to the second correction means and vice versa, the switching means being controlled by the discriminator means.

7. Equalizer device according to claim 6 characterized in that the first and second correction means are constituted by a single circuit whose gain can be set to either of two values by simple switching of a resistor (R10).

8. Equalizer device according to claim 7 characterized in that switching of the resistor (R10) is effected by means of a transistor (T1) controlled by the discriminator means (O4).

9. Equalizer device according to any one of claims 6 to 8 characterized in that it comprises a zero-crossing detector associated with the discriminator (O4) in order to effect the switching on a zero-crossing of the signal.

10. Equalizer device according to any one of claims 6 to 9 characterized in that it comprises variable time-delay means governing return from the second correction means to the first correction means after the transient.
